# EUROPÄISCHE PATENTSCHRIFT

(11) **EP 4 434 069 B1**
(45) Veröffentlichungstag und Bekanntmachung des Hinweises auf die Patenterteilung: **05.11.2025**
(21) Anmeldenummer: 22817766.3
(22) Anmeldetag: 17.11.2022
(51) Int. Cl.: H01H 71/04

(54) **NIEDERSPANNUNGSGERÄT**
A LOW VOLTAGE DEVICE
UN DISPOSITIF BASSE TENSION

(30) Priorität: 18.11.2021 DE 202021106291 U
(43) Veröffentlichungstag der Anmeldung: 25.09.2024
(73) Patentinhaber: Future Systems Besitz GmbH, 96472 Rödental (DE)
(72) Erfinder: MASEL, Joram, 96328 Küps (DE); STEINBERGER, Philipp, 96450 Coburg (DE)
(74) Vertreter: Bratovic, Nino Maria
(86) Internationale Anmeldenummer: PCT/EP2022/082210
(87) Internationale Veröffentlichungsnummer: WO 2023/089002

(56) Entgegenhaltungen:
- EP-A1- 2 624 276
- CN-U- 206 931 250
- DE-A1- 102011 006 112
- US-B2- 9 413 103

## Beschreibung

Die Erfindung betrifft ein Niederspannungsgerät für elektrische Verteiler und Schaltschrankinstallationen.

Die DE 10 2011 006 112 A1 beschreibt ein Niederspannungsgerät mit einem Schaltergehäuse und einem Anzeigebildschirm, der gegenüber dem Schaltergehäuse beweglich ist. Der flache Anzeigebildschirm befindet sich auf der Innenseite oder auf der Außenseite eines flachen unflexiblen Trägers, der um eine Schwenkachse herum gegenüber dem Schaltergehäuse geschwenkt werden kann. Der flache Träger lässt sich zusammen mit dem Anzeigebildschirm nach dem Schwenken um die Schwenkachse optional in einen Schlitz des Schaltergehäuses einführen.

Ein Schaltschrank beinhaltet elektrische und/oder elektronische Komponenten für eine verfahrenstechnische Anlage, beispielsweise eine Fertigungsanlage. Ein Schaltschrank kann verschiedenartige Niederspannungsgeräte enthalten, an die elektrische Lasten anschließbar sind. Als Niederspannung bezeichnet man allgemein Wechselspannungen bis etwa 1000 Volt sowie Gleichspannungen bis etwa 1500 Volt. Die Niederspannungsgeräte können unterschiedliche Funktionen zum Steuern oder Regeln von angeschlossenen Lasten erfüllen. Die verschiedenen Niederspannungsgeräte sind beispielsweise auf Stromsammelschienen montierbar, um elektrische Leistung zu verteilen. Niederspannungsgeräte werden vor allem in Schaltschränken oder Kleinverteilergehäusen montiert. Derartige Niederspannungsgeräte umfassen beispielsweise Sicherungslasttrennschalter oder Motorsteuergeräte. Der Einsatz von Niederspannungsgeräten in Automatisierungsanlagen verlangt eine relativ hohe Betriebslebensdauer der jeweiligen Niederspannungsgeräte sowie eine hohe Ausfallsicherheit zur Vermeidung von Produktionsausfällen.

Herkömmliche Niederspannungsgeräte verfügen über einfache Anzeigeelemente, wie beispielsweise Leuchtdioden, um einen Fehlerzustand des Niederspannungsgerätes anzuzeigen. Aufgrund des geringen verfügbaren Bauraums innerhalb eines Schaltschrankes oder Kleinverteilergehäuses verfügen herkömmliche Niederspannungsgeräte über einfache Anzeigeeinheiten bzw. Displays mit kleinen Anzeigeflächen, sodass darauf nur einfache Hinweise angezeigt werden können. Das Anzeigen von weiterführenden Informationen hinsichtlich des Schaltschrankes oder des entsprechenden Niederspannungsgerätes, wie beispielsweise eine Betriebsanleitung, ist mit derartigen einfachen Anzeigeeinheiten nicht möglich. Niederspannungsgeräte weisen aufgrund ihrer unterschiedlichen technischen Funktionen Gehäuse mit unterschiedlichen Gehäuseformen auf. In vielen Niederspannungsgeräten haben die Gehäuse aufgrund der speziellen technischen Funktionalität des entsprechenden Niederspannungsgerätes teilweise stark gekrümmte Konturen bzw. Oberflächen.

Es ist daher eine Aufgabe der vorliegenden Erfindung, ein Niederspannungsgerät für elektrische Verteiler oder Schaltschrankinstallationen zu schaffen, welches in der Lage ist, einem Nutzer über eine Nutzerschnittstelle komplexe Informationen zu vermitteln, ohne zusätzlichen Bauraum innerhalb eines Schaltschrankgehäuses oder Kleinverteilergehäuses zu beanspruchen.

Diese Aufgabe wird erfindungsgemäß durch ein Niederspannungsgerät mit den im Anspruch 1 angegebenen Merkmalen gelöst.

Die Erfindung schafft demnach ein Niederspannungsgerät für elektrische Verteiler und Schaltschrankinstallationen mit Bauteilen, die in einem Gehäuse des Niederspannungsgerätes enthalten sind, wobei das Gehäuse des Niederspannungsgerätes aufweist:
eine Montageschnittstelle zur Montage des Gehäuses des Niederspannungsgeräte an eine entsprechende Gegenschnittstelle des elektrischen Verteilers oder eines Schaltschrankes oder an eine in dem elektrischen Verteiler oder an eine in dem Schaltschrank eingebaute Komponente; und
einen Anzeigegehäuseabschnitt des Gehäuses, der für eine Anzeigeeinheit des Niederspannungsgerätes vorgesehen ist und eine flexible ausgebildete biegbare und/oder faltbare Anzeigeeinheit aufweist, wobei die flexible Anzeigeeinheit gebogen an eine Kontur des Anzeigegehäuseabschnittes des Gehäuses des Niederspannungsgerätes angepasst vorgesehen ist oder gefaltet an dem Anzeigegehäuseabschnitt des Gehäuses des Niederspannungsgerätes vorgesehen ist und dort zur Vergrößerung einer Anzeigefläche der Anzeigeeinheit entfaltbar ist.

Die flexible Anzeigeeinheit des Niederspannungsgerätes ist bei einer möglichen Ausführungsform an eine nicht ebene bzw. gekrümmte Kontur des Gehäuses fest oder abnehmbar angebracht. Bei einer alternativen Ausführungsform ist die flexible Anzeigeeinheit an dem Anzeigegehäuseabschnitt des Gehäuses gefaltet vorgesehen und kann durch einen Nutzer manuell oder automatisch zur Vergrößerung einer Anzeigefläche der Anzeigeeinheit entfaltet werden.

Die flexible Anzeigeeinheit weist vorzugsweise eine Anzeigeschicht mit einer Dicke von weniger als 0,1 mm auf. Diese Anzeigeschicht befindet sich vorzugsweise auf einer unteren Schutz- bzw. Trägerschicht. Darüber hinaus befindet sich an der Vorderseite der Anzeigeschicht vorzugsweise eine weitere transparente Schutzschicht.

Bei einer möglichen Ausführungsform des erfindungsgemäßen Niederspannungsgerätes weist die flexible Anzeigeeinheit eine Anzeigeschicht mit einem Biegeradius von weniger als 1,0 mm aufweist.

Bei einer weiteren möglichen Ausführungsform des erfindungsgemäßen Niederspannungsgerätes weist die flexible Anzeigeeinheit eine berührungssensitive Anzeigeschicht für Nutzereingaben eines Nutzers und zur Anzeige von Informationen an einen Nutzer auf.

Bei einer weiteren möglichen Ausführungsform des erfindungsgemäßen Niederspannungsgerätes weist das Gehäuse des Niederspannungsgerätes eine Montageschnittstelle zur Montage des Niederspannungsgerätes an mindestens eine Stromsammelschiene eines Sammelschienensystems des Schaltschrankes oder des elektrischen Verteilers und zur elektrischen Kontaktierung der Stromsammelschiene auf.

Bei einer weiteren möglichen Ausführungsform des erfindungsgemäßen Niederspannungsgerätes weist das Gehäuse des Niederspannungsgerätes eine Montageschnittstelle zur Montage des Niederspannungsgerätes an eine Hutschiene oder an eine Montageplatte des Schaltschrankes oder des elektrischen Verteilers auf.

Bei einer weiteren möglichen Ausführungsform des erfindungsgemäßen Niederspannungsgerätes ist die flexible Anzeigeeinheit an eine an dem Anzeigegehäuseabschnitt des Gehäuses des Niederspannungsgerätes vorgesehene Datenschnittstelle und/oder an eine Stromversorgungsschnittstelle abnehmbar angebracht.

Bei einer weiteren möglichen Ausführungsform des erfindungsgemäßen Niederspannungsgerätes besteht der Anzeigegehäuseabschnitt des Gehäuses des Niederspannungsgerätes aus einem transparenten Material, in welchem die flexible Anzeigeschicht der Anzeigeeinheit eingebettet ist.

Bei einer möglichen Ausführungsform des erfindungsgemäßen Niederspannungsgerätes weist die flexible Anzeigeschicht eine OLED-Anzeigeschicht auf.

Bei einer weiteren möglichen Ausführungsform des erfindungsgemäßen Niederspannungsgerätes weisen die in dem Gehäuse des Niederspannungsgerätes enthaltenen Bauteile des Niederspannungsgerätes Leistungsbauteile auf, die während des Betriebes des Niederspannungsgerätes Wärme bzw. Hitze erzeugen.

Bei einer weiteren möglichen Ausführungsform des erfindungsgemäßen Niederspannungsgerätes ist der für die flexible Anzeigeeinheit vorgesehene Anzeigegehäuseabschnitt des Gehäuses des Niederspannungsgerätes durch eine Wärmeisolierung von den Leistungsbauteilen des Niederspannungsgerätes zum Schutz der flexiblen Anzeigeeinheit vor Hitze wärmeisoliert.

Bei einer weiteren möglichen Ausführungsform des erfindungsgemäßen Niederspannungsgerätes weisen die in dem Gehäuse des Niederspannungsgerätes enthaltenen Bauteile eine Steuereinheit auf, die über eine in dem Anzeigegehäuseabschnitt des Gehäuses des Niederspannungsgerätes vorgesehene Datenschnittstelle Daten mit der an dem Anzeigegehäuseabschnitt vorgesehenen flexiblen Anzeigeeinheit austauscht.

Bei einer weiteren möglichen Ausführungsform des erfindungsgemäßen Niederspannungsgerätes weisen die in dem Gehäuse des Niederspannungsgerätes enthaltenen Bauteile einen Transceiver auf, der über einen Transceiver des Schaltschrankes oder des elektrischen Verteilers eine drahtlose Kommunikationsverbindung mit einer Steuereinheit des Schaltschrankes oder des elektrischen Verteilers bereitstellt.

Bei einer weiteren möglichen Ausführungsform des erfindungsgemäßen Niederspannungsgerätes ist in der Anzeigefläche der flexiblen Anzeigeeinheit eine Kamera integriert.

Mithilfe dieser Kamera kann eine Steuereinheit des Niederspannungsgerätes die unmittelbare Umgebung des Niederspannungsgerätes innerhalb des Schaltschrankgehäuses bzw. Kleinverteilergehäuses beobachten bzw. überwachen.

Bei einer weiteren möglichen Ausführungsform des erfindungsgemäßen Niederspannungsgerätes besteht das Gehäuse des Niederspannungsgerätes aus einem elektrisch isolierenden und feuerfesten Material.

Bei einer möglichen Ausführungsform des erfindungsgemäßen Niederspannungsgerätes weist das Niederspannungsgerät einen Lasttrennschalter mit Sicherungen auf.

Bei einer weiteren möglichen Ausführungsform des erfindungsgemäßen Niederspannungsgerätes weist das Niederspannungsgerät einen Sicherungslasttrennschalter auf.

Bei einer weiteren möglichen Ausführungsform des erfindungsgemäßen Niederspannungsgerätes weist das Niederspannungsgerät einen Lasttrennschalter auf.

Bei einer weiteren möglichen Ausführungsform des erfindungsgemäßen Niederspannungsgerätes weist das Niederspannungsgerät einen Leistungsschalter auf.

Bei einer weiteren möglichen Ausführungsform des erfindungsgemäßen Niederspannungsgerätes weist das Niederspannungsgerät ein Motorsteuergerät auf.

Bei einer weiteren möglichen Ausführungsform des erfindungsgemäßen Niederspannungsgerätes weist das Niederspannungsgerät ein Netzteil auf.

Bei einer weiteren möglichen Ausführungsform des erfindungsgemäßen Niederspannungsgerätes weist das Niederspannungsgerät einen Frequenzumrichter auf.

Bei einer weiteren möglichen Ausführungsform des erfindungsgemäßen Niederspannungsgerätes weist das Niederspannungsgerät ein Stromeinspeisemodul auf.

Bei einer weiteren möglichen Ausführungsform des erfindungsgemäßen Niederspannungsgerätes ist in dem Gehäuse des Niederspannungsgerätes eine Daten- und/oder Steuerschnittstelle zum Anschluss einer kapazitiven Last, einer induktiven Last oder einer resistiven Last an das Niederspannungsgerät vorgesehen.

Bei einer weiteren möglichen Ausführungsform des erfindungsgemäßen Niederspannungsgerätes weisen die auf der flexiblen Anzeigeeinheit des Niederspannungsgerätes angezeigten Informationen auf:
Statusinformationen des Niederspannungsgerätes oder anderer in dem Schaltschrank oder Verteiler montierter Niederspannungsgeräte,
Konfigurationsangaben des Niederspannungsgerätes oder anderer in dem Schaltschrank oder Verteiler montierter Niederspannungsgeräte,
Messdaten des Niederspannungsgerätes oder anderer in dem Schaltschrank oder Verteiler montierter Niederspannungsgeräte,
einen Stromlaufplan des Niederspannungsgerätes und/oder eines anderen in dem Schaltschrank oder Verteiler montierten Niederspannungsgerätes oder einen Stromlaufplan der in dem Schaltschrank oder Verteiler montierten Niederspannungsgeräte,
eine Betriebsanleitung für den Betrieb des Niederspannungsgerätes oder des Verteilers bzw. Schaltschrankes,
eine Servicenummer für einen Wartungsservice zur Wartung des Schaltschrankes oder Verteilers und/oder des Niederspannungsgerätes oder weiterer Niederspannungsgeräte innerhalb des Schaltschrankes oder Verteilers und/oder
Statusinformationen mindestens einer an dem Niederspannungsgerät angeschlossenen Last.

Bei einer weiteren möglichen Ausführungsform des erfindungsgemäßen Niederspannungsgerätes ist die entfaltete flexible Anzeigeeinheit schwenkbar an dem Gehäuse des Niederspannungsgerätes angebracht.

Bei einer weiteren möglichen Ausführungsform
des erfindungsgemäßen Niederspannungsgerätes bildet eine entfaltete flexible Anzeigeeinheit des Niederspannungsgerätes mit einer weiteren entfalteten flexiblen Anzeigeeinheit eines auf der Schiene des Schaltschrankes oder Verteilers daneben montierten Niederspannungsgerätes eine zusammengesetzte Anzeigeeinheit mit großer Anzeigefläche.

Bei einer möglichen Ausführungsform weist das Niederspannungsgeräteine in dem Gehäuse integrierte Steuereinheit aufweist, die über eine Daten und Steuerschnittstelle mit der Anzeigeeinheit und mit einer Kamera verbunden ist.

Bei einer möglichen Ausführungsform weist die Steuereinheit ein künstliches Intelligenzmodul zur Klassifizierung der von der Kamera bereitgestellten Bilddaten.

Bei einer weiteren möglichen Ausführungsform des erfindungsgemäßen Niederspannungsgerätes ist die Anzeigeeinheit des Niederspannungsgerätes über ein drahtgebundenes oder drahtloses Bussystem des Schaltschrankes oder Verteilers mit anderen Geräten des Schaltschrankes oder Verteilers zur Datenübertragung verbunden.

Bei einer weiteren möglichen Ausführungsform des erfindungsgemäßen Niederspannungsgerätes ist die Anzeigeeinheit des Niederspannungsgerätes an ein Intranet einer Automatisierungsanlage und/oder über ein Gateway an das Internet angebunden.

Bei einer weiteren möglichen Ausführungsform des erfindungsgemäßen Niederspannungsgerätes ist die Anzeigeeinheit an eine akustische Nutzerschnittstelle des Niederspannungsgerätes und/oder des Schaltschrankes oder Verteilers gekoppelt.

Bei einer weiteren möglichen Ausführungsform des erfindungsgemäßen Niederspannungsgerätes weist die flexible Anzeigeeinheit eine flexible hintere Trägerschicht zum Tragen der Anzeigeschicht der Anzeigeeinheit und eine flexible vordere transparente Schutzschicht zum Schutz der Anzeigeschicht der Anzeigeschicht auf.

Bei einer weiteren möglichen Ausführungsform des erfindungsgemäßen Niederspannungsgerätes ist die Anzeigeeinheit entlang mindestens einer Faltlinie jeweils mit einem bestimmten Biegeradius faltbar ist.

Die Erfindung schafft gemäß einem weiteren Aspekt einen Schaltschrank mit Schienen zur Montage verschiedener Niederspannungsgeräte gemäß dem ersten Aspekt der Erfindung.

Die Erfindung schafft gemäß einem weiteren Aspekt einen elektrischen Verteiler mit Niederspannungsgeräten gemäß dem ersten erfindungsgemäßen Aspekt.

Im Weiteren werden mögliche Ausführungsformen des erfindungsgemäßen Niederspannungsgerätes zur Montage in einem Schaltschrank oder einem elektrischen Verteiler unter Bezugnahme auf die beigefügten Figuren näher erläutert.

Es zeigen:
- Fig. 1: eine perspektivische Ansicht auf ein einfaches Ausführungsbeispiel eines erfindungsgemäßen Niederspannungsgerätes;
- Fig. 2: eine weitere Ansicht auf eine mögliche Ausführungsform eines erfindungsgemäßen Niederspannungsgerätes;
- Fig. 3: eine schematische Schnittansicht zur Darstellung der Funktionalität eines exemplarischen Niederspannungsgerätes;
- Figuren 4A, 4B: Schnittansichten zur Darstellung unterschiedlicher Ausführungsformen des erfindungsgemäßen Niederspannungsgerätes;
- Figuren 5A, 5B: Ansichten zur Darstellung einer möglichen Ausführungsform des erfindungsgemäßen Niederspannungsgerätes;
- Figuren 6A, 6B: weitere Ansichten zur Darstellung eines weiteren Ausführungsbeispiels eines erfindungsgemäßen Niederspannungsgerätes;
- Fig. 7: eine weitere Ansicht zur Darstellung eines weiteren Ausführungsbeispiels eines erfindungsgemäßen Niederspannungsgerätes;
- Fig. 8: eine Darstellung eines Ausführungsbeispiels eines erfindungsgemäßen Niederspannungsgerätes;
- Fig. 9: eine Darstellung eines weiteren Ausführungsbeispiels eines erfindungsgemäßen Niederspannungsgerätes.

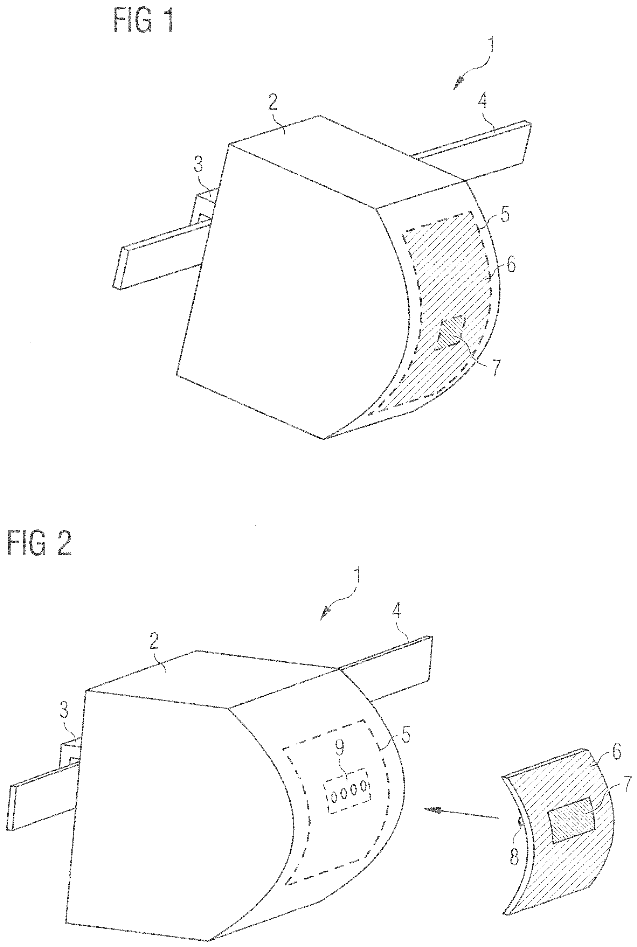

Fig. 1 zeigt eine perspektivische Ansicht eines erfindungsgemäßen Niederspannungsgerätes 1, das beispielsweise in einem elektrischen Verteiler oder in einem Schaltschrank montiert werden kann. Das Niederspannungsgerät 1 kann unterschiedliche technische Funktionen innerhalb des Schaltschrankes bzw. elektrischen Verteilers bereitstellen. Das Niederspannungsgerät 1 umfasst unterschiedliche Bauteile, die in einem Gehäuse 2 des Niederspannungsgerätes 1 enthalten sind. Das Gehäuse 2 des Niederspannungsgerätes 1 kann aus einem elektrisch isolierenden und feuerfesten Material bestehen.

Das Niederspannungsgerät 1 weist bei dem in Fig. 1 dargestellten Ausführungsbeispiel an seiner Rückseite eine elektromechanische Montageschnittstelle 3 zur Montage des Gehäuses 2 an eine entsprechende Gegenschnittstelle des elektrischen Schaltschrankes oder Verteilers oder an eine in dem elektrischen Verteiler oder Schaltschrank eingebaute Komponente auf. Bei dieser in dem Schaltschrank eingebauten Komponente handelt es sich beispielsweise um einen elektromechanischen Adapter. In dem dargestellten Ausführungsbeispiel gemäß Fig. 1 beinhaltet der Schaltschrank oder Verteiler eine horizontal montierte Schiene 4, die an einer Montageplattform angebracht ist. Die Schiene 4 kann aber auch vertikal montiert werden. Bei dem in Fig. 1 dargestellten Ausführungsbeispiel handelt es sich bei der Schiene 4 um eine Stromsammelschiene. Alternativ kann das Gehäuse 2 des Niederspannungsgerätes 1 auch auf eine Hutschiene oder eine Montageplatte des Verteilers bzw. Schaltschrankes montiert werden. Eine Tragschiene bzw. Hutschiene mit Hutprofil ist ein universaler Träger, der aus einem Blechprofil hergestellt ist und zur Befestigung von elektrischen Betriebsmitteln an einen Verteilerkasten, Schaltschrank oder Anschlusskasten verwendet werden kann. Auf einer derartigen Trag- bzw. Hutschiene können unterschiedliche Bauteile seitlich aufgeschoben oder von vorne aufgesteckt und arretiert werden. Bei einer weiteren möglichen Ausführungsform kann das Gehäuse 2 des Niederspannungsgerätes 1 mittels Befestigungsmitteln, beispielsweise Schrauben, direkt auf eine Montageplatte des Schaltschrankes oder Verteilers befestigt werden. Die Montage des Niederspannungsgerätes 1 auf die Stromsammelschiene, die Hutschiene oder an der Montageplatte erfolgt vorzugsweise werkzeuglos durch direktes Aufsetzen und Arretieren.

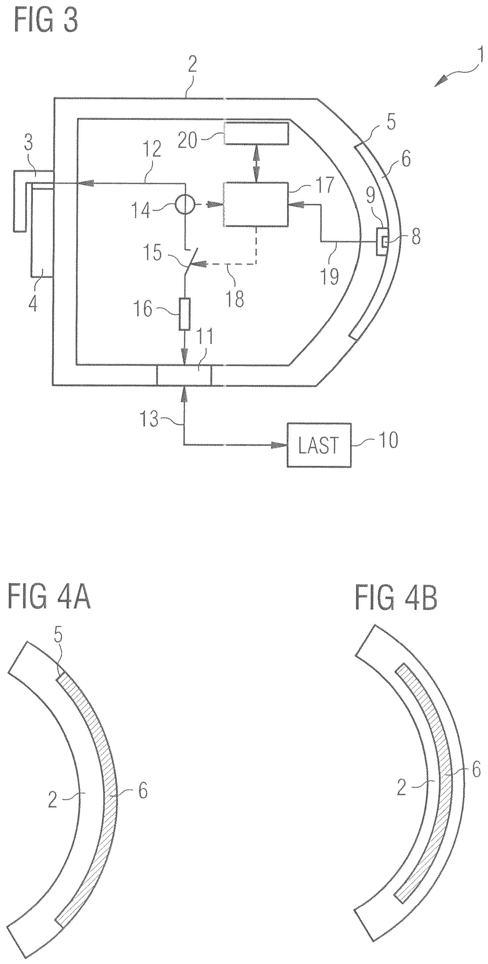

Bei dem in Fig. 1 dargestellten Ausführungsbeispiel dient die Stromsammelschiene 4 nicht nur zur mechanischen Montage des Niederspannungsgerätes 1, sondern führt auch einen elektrischen Strom, der über elektrische Kontakte an der Montageschnittstelle 3 dem Niederspannungsgerät 1 zugeführt werden kann. An dem Niederspannungsgerät 1 können über weitere Schnittstellen 11 Lasteinheiten 10 angeschlossen werden, wie auch in Fig. 3 dargestellt.

Das Gehäuse 2 des Niederspannungsgerätes 1 verfügt über einen Anzeigegehäuseabschnitt 5, der für eine Anzeigeeinheit 6 des Niederspannungsgerätes 1 vorgesehen ist. Der Anzeigegehäuseabschnitt 5 weist eine flexibel ausgebildete biegbare und/oder faltbare Anzeigeeinheit 6 auf. Die flexible Anzeigeeinheit 6 ist gebogen an eine Kontur des Anzeigegehäuseabschnittes 5 des Gehäuses 2 des Niederspannungsgerätes 1 angepasst vorgesehen. Die Form der biegbaren Anzeigeeinheit 6 passt sich somit der gekrümmten Kontur des Anzeigegehäuseabschnittes 5 an, wie in Fig. 1 schematisch dargestellt.

Die flexible Anzeigeeinheit 6 weist bei einer möglichen Ausführungsform eine Anzeigeschicht auf, die beispielsweise auf einer Träger- und Schutzschicht vorgesehen ist. Die Anzeigeschicht weist bei einer möglichen Ausführungsform eine Dicke von weniger als 0,1 mm auf. Auf beiden Seiten der Anzeigeschicht kann sich eine Schutzschicht befinden. Die hintere Schutzschicht dient beispielsweise zusätzlich als Trägerschicht für die Anzeigeschicht. Die vordere transparente Schutzschicht schützt die Anzeigeschicht der Anzeigeeinheit 6 vor der Umgebung innerhalb der Automatisierungsanlage, insbesondere gegenüber mechanischen Einflüssen. Weiterhin bietet die vordere transparente Schutzschicht Schutz gegenüber Staub und Feuchtigkeit.

Die hintere Trägerschicht und die vordere transparente Schutzschicht der flexiblen Anzeigeeinheit 6 bestehen vorzugsweise jeweils aus einem biegbaren elastischen Material, welches es erlaubt die Anzeigeeinheit 6 entlang einer geraden Faltlinie FL mit einem bestimmten Biegeradius R zu falten und wieder zu entfalten. Die hintere Trägerschicht kann eine Dicke von weniger als 1 mm aufweisen.

Die in Fig. 1 dargestellte flexible Anzeigeeinheit 6 weist bei einer bevorzugten Ausführungsform eine berührungssensitive Anzeigeschicht zur Eingabe eines Nutzers und zur Anzeige von Informationen an einen Nutzer auf.

Bei einer bevorzugten Ausführungsform weist die flexible Anzeigeschicht der Anzeigeeinheit 6 eine OLED (Organic Light-Emitting Diode)-Schicht auf. Die OLED-Anzeigeschicht enthält organische Leuchtdioden und ein leuchtendes Dünnschichtbauelement aus organischen halbleitenden Materialien.

In dem Gehäuse 2 des Niederspannungsgerätes 1 können sich unterschiedliche elektrische, elektronische und mechanische Bauteile bzw. Komponenten befinden, um die entsprechende Funktionalität des Niederspannungsgerätes 1 bereitzustellen.

In dem Gehäuse 2 des Niederspannungsgerätes 1 befinden sich bei einer möglichen Ausführungsform Leistungsbauteile, die während des Betriebes des Niederspannungsgerätes 1 oder bei Auftreten von Kurzschlussströmen oder Überspannungen Wärme bzw. Hitze erzeugen. Bei einer bevorzugten Ausführungsform des erfindungsgemäßen Niederspannungsgerätes 1 weist der für die flexible Anzeigeeinheit 6 vorgesehene Anzeigegehäuseabschnitt 5 des Gehäuses 2 des Niederspannungsgerätes 1 eine Wärmeisolierung, beispielsweise eine Wärmeisolierungsschicht, auf. Diese Wärmeisolierung bietet einen thermischen Schutz der flexiblen Anzeigeeinheit 6 gegenüber der Wärme bzw. Hitze, die von den in dem Gehäuse 2 des Niederspannungsgerätes 1 enthaltenen Leistungsbauteilen während des Betriebes des Niederspannungsgerätes 1 erzeugt wird.

Bei einer weiteren Ausführungsform ist die hintere Träger-und Schutzschicht der Anzeigeeinheit 6 auf einer wärmeisolierenden Schicht der Anzeigeeinheit 6 vorgesehen sein, welche die die Anzeigeschicht der Anzeigeeinheit 6 gegenüber Wärme bzw. Hitze innerhalb des Gehäuses 2 schützt, die durch Leistungsbauteile des Niederspannungsgerätes 1 während des Betriebes des Niederspannungsgerätes oder bei Auftreten von Kurzschlüssen oder Überspannungen entsteht. Alternativ besteht die Träger- und Schutzschicht der Anzeigeeinheit 6 aus einem wärmeisolierenden Material. Bei einer weiteren Ausführungsform weist sowohl der Gehäuseabschnitt 5 als auch die Anzeigeeinheit 6 eine wärmeisolierende Schicht auf.

Bei einer möglichen Ausführungsform des Niederspannungsgerätes 1 enthält dessen Gehäuse 2 einen Temperatursensor, der die Temperatur T im Inneren des Gehäuses 2 überwacht. Die Temperatur T kann auf der Anzeigeeinheit 6 angezeigt werden. Übersteigt der Temperaturwert einen Temperaturschwellenwert kann der Nutzer über die Anzeigeeinheit 6 aufgefordert werden die Anzeigeeinheit 6 zu deren Schutz von dem Gehäuseabschnitt 5 abzunehmen und/oder eine lokal vorgesehene Kühlung, beispielsweise einen Ventilator, zu aktivieren. Die Aktivierung der Kühlung kann auch automatisch bei Überschreiten eines Tempertuschwellenwertes erfolgen.

Weiterhin können die in dem Gehäuse 2 des Niederspannungsgerätes 1 enthaltenen Bauteile auch elektronische Komponenten umfassen, insbesondere eine Steuereinheit bzw. Controller 17, wie in Fig. 3 gezeigt. Die in dem Gehäuse 2 enthaltene Steuereinheit 17 kann über eine in dem Anzeigegehäuseabschnitt 5 des Gehäuses 2 des Niederspannungsgerätes 1 vorgesehene Anzeigedatenschnittstelle 9, wie sie in Fig. 2 schematisch dargestellt ist, Daten mit der an dem Anzeigegehäuseabschnitt 5 vorgesehenen flexiblen Anzeigeeinheit 6 austauschen.

Neben der Steuereinheit 17 kann sich zusätzlich in dem Gehäuse 2 des Niederspannungsgerätes 1 bei einer möglichen Ausführungsform ein Transceiver 20 befinden. Dieser Transceiver 20 stellt mit einem Transceiver des Schaltschrankes oder des elektrischen Verteilers eine drahtlose Kommunikationsverbindung mit einer Steuereinheit des Schaltschrankes oder Verteilers her. Auf diese Weise kann die in dem Gehäuse 2 des Niederspannungsgerätes 1 integrierte Steuereinheit 17 mit der Steuereinheit des Schaltschrankes oder Verteilers Daten austauschen, insbesondere Sensor- oder Messdaten, die auf der Anzeigeeinheit 6 des Niederspannungsgerätes 1 einem Nutzer angezeigt werden können.

Bei einer möglichen Ausführungsform ist in die Anzeigefläche der in Fig. 1 dargestellten flexiblen Anzeigeeinheit 6 mindestens eine Kamera 7 integriert. Bei einer Montage des Niederspannungsgerätes 1 an einer Schiene eines Schaltschrankes oder Verteilers zeigt die Kamera 7 vorzugsweise nach vorne hin zu einer Schaltschranktür des Schaltschrankes oder Verteilers. Die in der Anzeigeeinheit 6 integrierte Kamera 7 erlaubt es, in ihrem Sichtfeld die unmittelbare Montageumgebung des Niederspannungsgerätes 1 innerhalb des Schaltschrankes oder Verteilers zu überwachen. Hierzu kann vorzugsweise an der Innenseite der Schaltschranktür eine reflektierende oder spiegelnde Oberfläche vorgesehen sein. Sind mehrere Niederspannungsgeräte 1 nebeneinander auf einer Schiene, beispielsweise auf einer Stromsammelschiene 4, montiert, kann die Kamera 7 eines Niederspannungsgerätes 1 erkennen, welche weiteren Niederspannungsgeräte 1 in der unmittelbaren Montageumgebung des Niederspannungsgerätes 1 verbaut sind. Darüber hinaus kann die in der Anzeigefläche der Anzeigeeinheit 6 integrierte Kamera 7 auch überwachen, ob Anzeigeelemente der übrigen Niederspannungsgeräte 1 optische Signale abgeben. Leuchtet beispielsweise eine LED eines benachbarten Niederspannungsgerätes 1 auf, kann dies durch die Kamera 7 der Anzeigeeinheit 6 erkannt werden. In Fig. 1 ist die in der Anzeigefläche integrierte Kamera 7 schematisch dargestellt. In der Anzeigefläche der Anzeigeeinheit 6 können auch mehrere optisch sensitive Flächen bzw. Kameras 7 integriert sein. Die in der Anzeigeeinheit 6 integrierte Kamera 7 ist vorzugsweise mit einer Steuereinheit 17 innerhalb des Gehäuses 2 des Niederspannungsgerätes 1 über eine Datenschnittstelle verbunden.

Darüber hinaus kann in dem Gehäuse 2 des Niederspannungsgerätes 1 eine weitere Daten- und Steuerschnittstelle 11 vorgesehen sein, die zum Anschluss einer kapazitiven Last, einer induktiven Last oder einer resistiven Last an das Niederspannungsgerät 1 vorgesehen ist. Bei der induktiven Last handelt es sich beispielsweise um einen Elektromotor. Bei der resistiven Last handelt es sich beispielsweise um ein Heizelement oder dergleichen. Diese Daten- und Steuerschnittstelle 11 befindet sich beispielsweise an einer Unterseite des Gehäuses 2 des in Fig. 1 dargestellten Niederspannungsgerätes 1, wie in Fig. 3 dargestellt. Bei einer möglichen Ausführungsform ist die Last 10 über elektrische Kabel 13 an die Daten- und Steuerschnittstelle 11 des Niederspannungsgerätes 1 angeschlossen. Bei einer möglichen Ausführungsform dient die Kamera 7 des Niederspannungsgerätes 1 zusätzlich dazu, einen korrekten Anschluss der Verdrahtungskabel 13, welche die Last 10 mit der Daten- und Steuerschnittstelle 9 verbinden, zu überwachen. Fehlt beispielsweise ein elektrisches Verbindungskabel 13 einer Stromphase L für die Last 10, kann dies nach Auswertung des Kamerabildes, welches von der Kamera 7 geliefert wird, durch die Steuereinheit 17 des Niederspannungsgerätes 1 automatisch erkannt werden und ggf. über eine Datenschnittstelle an eine Steuereinheit des Schaltschrankes oder Verteilers gemeldet werden. Bei einer möglichen Ausführungsform werden die Kamerabilder der Kamera 7 über eine drahtlose Kommunikationsverbindung an eine Steuereinheit des Schaltschrankes oder Verteilers oder an einen Server übertragen und dort ausgewertet. Bei dieser Ausführungsform verfügt die Steuereinheit des Schaltschrankes oder Verteilers oder der Server vorzugsweise über eine Bilderkennungseinheit zur Auswertung von Kamerabildern bzw. Bilddaten und/oder über ein entsprechen trainiertes künstliches neuronales Netz (CNN, RNN) .

Bei einer möglichen Ausführungsform kommunizieren verschiedene Niederspannungsgeräte 1 über eine drahtlose Kommunikationsverbindung miteinander. Beispielsweise können Niederspannungsgeräte 1, die nicht über eine eigene Anzeigeeinheit 6 verfügen, Sensordaten oder sonstige Informationen über die drahtlose Kommunikationsverbindung an das in Fig. 1 dargestellte Niederspannungsgerät 1 übermitteln, welche die erhaltenen Informationen auf seiner Anzeigeeinheit 6 einem Nutzer anzeigen.

Bei einer möglichen Ausführungsform handelt es sich bei dem in Fig. 1 dargestellten Niederspannungsgerät 1 um ein auf Anzeigefunktionen spezialisiertes Anzeigeniederspannungsgerät, welches zur Anzeige von Informationen auf einer gekrümmten Anzeigefläche des Gehäuses 2 ausgelegt ist.

Auf der flexiblen Anzeigeeinheit 6 des Niederspannungsgerätes 1 können unterschiedliche Informationen angezeigt werden. So werden bei einer möglichen Ausführungsform der flexiblen Anzeigeeinheit 6 Statusinformationen des Niederspannungsgerätes 1 oder anderer in dem Schaltschrank oder Verteiler montierter Niederspannungsgeräte 1 oder sonstiger Geräte einem Nutzer angezeigt.

Darüber hinaus kann die flexible Anzeigeeinheit 6 bei einer möglichen Ausführungsform Konfigurationsangaben oder Parameter des Niederspannungsgerätes 1 oder anderer in dem Schaltschrank oder Verteiler montierter Niederspannungsgeräte 1 oder sonstiger Geräte einem Nutzer optisch anzeigen.

Weiterhin können auch Messdaten des Niederspannungsgerätes 1 oder anderer in dem Schaltschrank montierter Geräte auf der Anzeigeeinheit 6 angezeigt werden.

Die flexible Anzeigeeinheit 6 des erfindungsgemäßen Niederspannungsgerätes 1 ist darüber hinaus auch in der Lage, komplexe Informationen an einen Nutzer optisch auszugeben. Beispielsweise kann bei einer möglichen Ausführungsform über die flexible Anzeigeeinheit 6 ein Stromlaufplan oder eine Bedienungsanleitung des Niederspannungsgerätes 1 und/oder eines anderen in dem Schaltschrank oder Verteiler montierten Niederspannungsgerätes 1 angezeigt werden.

Darüber hinaus können beispielsweise auch Servicenummern für einen Wartungsservice zur Wartung des Schaltschrankes und/oder des Niederspannungsgerätes 1 oder sonstiger Geräte innerhalb des Schaltschrankes oder Verteilers angezeigt werden. Diese Servicenummern umfassen beispielsweise eine Telefonnummer. Weiterhin können als Servicenummern auch IP-Adressen und Websites angezeigt werden.

Bei einer möglichen Ausführungsform wird auf der berührungssensitiven Anzeigeeinheit 6 ein Link zu einer Service Webpage (Uniform Resource Locator URL) angezeigt, sobald ein bestimmter Betriebszustand des Niederspannungsgerätes 1 oder des Schaltschrankes erkannt wird. Durch manuelles Pressen des angezeigten Links gelangt der Nutzer direkt auf die entsprechende Service Page, welche die notwendigen Informationen für den betreffenden Betriebszustand dem Nutzer bereitstellt. Weiterhin können über die flexible Anzeigeeinheit 6 des Niederspannungsgerätes 1 bei einer möglichen Ausführungsform auch Statusinformationen oder sonstige Daten einer an dem Niederspannungsgerät 1 angeschlossenen Last 10 angezeigt werden. Bei dieser Last 10 handelt es sich beispielsweise um eine kapazitive, resistive oder induktive Last. Beispielsweise kann ein an einem Motorsteuergerät 1 angeschlossener elektrischer Motor Wartungsinformationen an das Niederspannungsgerät bzw. den Motorstarter 1 liefern, welche über die Anzeigeeinheit 6 dem Nutzer angezeigt werden.

Die Anzeigeeinheit 6 des Niederspannungsgerätes 1 kann über ein drahtgebundenes oder drahtloses Bussystem des Schaltschrankes oder Verteilers mit anderen Geräten des Schaltschrankes, insbesondere mit anderen Niederspannungsgeräten 1 des Schaltschrankes, zur Durchführung einer Datenübertragung verbunden sein. Beispielsweise kann die Anzeigeeinheit 6 des Niederspannungsgerätes 1 an ein Intranet einer Automatisierungsanlage über eine Kommunikationsverbindung angebunden sein. Darüber hinaus kann die Anzeigeeinheit 6 des Niederspannungsgerätes 1 auch über ein Gateway mit dem Internet verbunden sein.

Bei einer möglichen Ausführungsform ist die Anzeigeeinheit 6 an eine akustische Nutzerschnittstelle des Niederspannungsgerätes 1 und/oder des Schaltschrankes oder Verteilers gekoppelt. Auf diese Weise ist es möglich, zusätzlich Informationen oder Warnsignale akustisch an einen Nutzer auszugeben. Weiterhin kann über die akustische Nutzerschnittstelle ein Nutzer auch Eingaben bzw. Befehle über ein Mikrofon eingeben, wobei die eingegebenen Informationen zusätzlich über die Anzeigeeinheit 6 dem Nutzer angezeigt werden, sodass dieser kontrollieren kann, ob seine akustische Eingabe korrekt verstanden wurde. Dies ist insbesondere in einer lauten Produktionsumgebung einer Automatisierungsanlage für den Nutzer hilfreich.

Fig. 2 zeigt schematisch ein Ausführungsbeispiel eines erfindungsgemäßen Niederspannungsgerätes 1 mit einer flexiblen Anzeigeeinheit 6. Bei dem in Fig. 2 dargestellten Ausführungsbeispiel kann die flexible Anzeigeeinheit 6 auf einen an dem Gehäuse 2 vorgesehenen zugehörigen Anzeigegehäuseabschnitt 5 aufgesetzt werden. Dabei passt sich die Form der flexiblen Anzeigeeinheit 6 an die Kontur bzw. Krümmung des Anzeigegehäuseabschnittes 5 des Gehäuses 2 an, wie in Fig. 2 schematisch dargestellt. Die flexible Anzeigeeinheit 6 verfügt vorzugsweise über eine Datenschnittstelle 8, die an eine entsprechende Datenschnittstelle 9 innerhalb des Gehäuseabschnittes 5 eingesetzt bzw. daran anschließbar ist. Neben der Datenschnittstelle 9 kann auch eine Stromversorgungsschnittstelle zur elektrischen Stromversorgung der flexiblen Anzeigeeinheit 6 vorgesehen sein. Die flexible Anzeigeeinheit 6 ist vorzugsweise an die an dem Anzeigegehäuseabschnitt 5 des Gehäuses 2 des Niederspannungsgerätes 1 vorgesehene Datenschnittstelle und/oder an die zugehörige Stromversorgungsschnittstelle abnehmbar angebracht. Der Nutzer kann die flexible Anzeigeeinheit 6 manuell in den Anzeigegehäuseabschnitt 5 des Gehäuses 2 einsetzen. Auf diese Weise hat ein Nutzer die Möglichkeit, ein Niederspannungsgerät 1 bei Bedarf mit einer flexiblen Anzeigeeinheit 6 auszustatten, sofern er dies wünscht. Die Befestigung der flexiblen Anzeigeeinheit 6 ist somit lösbar und kann unterschiedlich ausgestaltet werden. Beispielsweise wird die flexible Anzeigeeinheit 6 mithilfe von Magneten an dem Anzeigegehäuseabschnitt 5 des Gehäuses 2 temporär angebracht. Alternativ kann die flexible Anzeigeeinheit 6 auch beispielsweise mithilfe eines Klettverschlusses an den Anzeigegehäuseabschnitt 5 befestigt werden.

Die flexible Anzeigeeinheit 6 bleibt bei einer bevorzugten Ausführungsform nach dem Abnehmen von dem Gehäuse 2 des Niederspannungsgerätes 1 eingeschaltet. Dabei kann ein Datenaustauch zwischen der Anzeigeeinheit 6 und dem Niederspannungsgerät 1 über eine drahtgebundene oder drahtlose Datenverbindung erfolgen. Eine Stromversorgung der der von dem Gehäuse 2 des Niederspannungsgerätes 1 abgenommenen Anzeigeeinheit 6 erfolgt über eine Stromverbindung oder durch einen in der Anzeigeeinheit 6 integrierten Energiespeicher.

Bei einer weiteren möglichen Ausführungsform kann die flexible Anzeigeeinheit 6 von einem Nutzer von dem Anzeigegehäuseabschnitt 5 manuell gelöst werden und auf einen Anzeigegehäuseabschnitt 5 eines anderen Niederspannungsgerätes 1 innerhalb des Schaltschrankes aufgesetzt werden. Dabei passt sich die flexible Anzeigeeinheit 6 an die Kontur bzw. Form des anderen Niederspannungsgerätes 1 an.

Die in Fig. 2 dargestellte abnehmbare flexible Anzeigeeinheit 6 kann ihrerseits über eine integrierte Kamera 7 verfügen, welche Kamerabilder der Montageumgebung des Niederspannungsgerätes 1 liefert.

Fig. 3 zeigt eine Schnittansicht durch ein mögliches Ausführungsbeispiel eines erfindungsgemäßen Niederspannungsgerätes 1. Fig. 3 zeigt eine Schnittansicht durch eine Gehäusewandung des Gehäuses 2 des Niederspannungsgerätes 1. An der in Fig. 3 dargestellten rechten Seite befindet sich ein Anzeigegehäuseabschnitt 5 zur Aufnahme einer flexiblen Anzeigeeinheit 6, deren Kontakte 8 in entsprechende Kontakte einer Daten- und/oder Stromversorgungsschnittstelle 9 des Niederspannungsgerätes 1 eingesetzt sind. Bei dem dargestellten Ausführungsbeispiel ist das Gehäuse 2 des Niederspannungsgerätes 1 über eine elektromechanische Montageschnittstelle 3 auf eine Stromsammelschiene 4 des Schaltschrankes oder Verteilers aufgesetzt. Die Stromsammelschiene 4 bietet die Möglichkeit, einen Gleich- oder Wechselstrom innerhalb des Verteilers oder Schaltschrankes zu verteilen. Wie in Fig. 3 schematisch dargestellt, ist eine Last 10 an eine Daten- und/oder Steuerschnittstelle 11 an der Unterseite des Gehäuses 2 angeschlossen. Bei der Last 10 handelt es sich beispielsweise um eine resistive Last, eine induktive Last oder um eine kapazitive Last. Der von der Stromsammelschiene 4 abgegriffene Strom kann über einen internen Stromversorgungspfad 12 und über Stromanschlussleitungen 13 der Last 10 zur Stromversorgung zugeführt werden. Bei dem in Fig. 3 dargestellten Beispiel können innerhalb des Gehäuses 2 zusätzliche Komponenten vorgesehen sein, beispielsweise ein Stromsensor 14, ein Schalter 15 oder eine Schmelzsicherung 16. Bei dem in Fig. 3 dargestellten Beispiel ist in dem Gehäuse 2 eine Steuereinheit 17 integriert, welche über eine interne Steuerleitung 18 den im Stromversorgungspfad 12 enthaltenen Schalter 15 ansteuert. Darüber hinaus ist die Steuereinheit 17 über interne Strom- und Datenleitungen 19 mit der Daten- und Stromversorgungsschnittstelle der Anzeigeeinheit 6 verbunden. Neben dem in Fig. 3 dargestellten Stromsensor 14 kann auch ein Spannungssensor zur Messung der an dem internen Stromversorgungspfad 12 angelegten elektrischen Spannung vorgesehen sein, welcher ein Spannungssignal liefert. Bei einer möglichen Ausführungsform werden die analogen Messsignale durch nicht dargestellte Analog-Digital-Wandler in Messdaten umgewandelt, die bei einer möglichen Implementierung in einem internen Datenspeicher der Steuereinheit 17 zwischengespeichert werden. Darüber hinaus können die von der Anzeigeeinheit 6 erzeugten Daten ebenfalls in dem internen Datenspeicher der Steuereinheit 17 zwischengespeichert werden. Diese Daten der flexiblen Anzeigeeinheit 6 geben beispielsweise an, welcher Bereich der Anzeigefläche durch die Fingerspitze eines Fingers eines Nutzers berührt worden ist. Diese Daten können in entsprechende Eingabebefehle übersetzt werden. Darüber hinaus liefert die in der Anzeigefläche integrierte Kamera 7 Bilddaten, die zeitweise in einem Datenspeicher der Speichereinheit 17 zwischengespeichert werden können. Darüber hinaus kann die Steuereinheit 17 mit einem integrierten Transceiver 20 verbunden sein, um die zwischengespeicherten Daten an eine externe Steuereinheit, insbesondere an eine Steuereinheit eines Schaltschrankes oder Verteilers, zu übertragen. Bei Auftreten eines Kurzschlusses innerhalb des Stromversorgungspfades liefert das integrierte Sensorelement 14 ein entsprechendes Messsignal, das zur Erkennung eines Kurzschlusses ausgewertet wird. Sobald ein Kurzschluss erkannt wird, kann die Steuereinheit 16 den integrierten Schalter automatisch öffnen, um den Schutzstrom zu unterbrechen und hierdurch die Last 10 zu schützen. Der erkannte Kurzschluss wird auf der flexiblen Anzeigeeinheit 6 dem Nutzer angezeigt. Sobald die Ursache für den Kurzschluss durch den Nutzer behoben worden ist, kann der Nutzer beispielsweise auf die berührungssensitive Anzeigefläche der Anzeigeeinheit 6 an einer entsprechenden Stelle drücken, um hierdurch ein Schließen des integrierten Schalters 15 durch die Steuereinheit 17 herbeizuführen.

Das in Fig. 3 dargestellte Niederspannungsgerät 1 ist lediglich beispielhaft, d.h., andere Niederspannungsgeräte können völlig unterschiedliche Bauteile und Komponenten enthalten. Das Vorsehen der integrierten Steuereinheit 17 ist optional. Bei einer alternativen Ausführungsform können die Daten der flexiblen Anzeigeeinheit 6 direkt über einen Transceiver 20 an eine externe Steuereinheit des Schaltschrankes oder Verteilers übertragen werden. Darüber hinaus kann die Anzeigeeinheit 6 auch Anzeigedaten direkt über einen Transceiver von einer externen Steuereinheit des Schrankschrankes oder Verteilers erhalten. Weiterhin können anzuzeigende Daten bzw. Informationen bei einer weiteren Ausführungsvariante auch mittels Powerline Communication PLC über die Stromsammelschiene 4 des Schaltschrankes oder Verteilers übertragen werden und auf der Anzeigeeinheit 6 angezeigt werden.

Die in der Anzeigeeinheit 6 integrierte Kamera 7 kann bei einer möglichen Ausführungsform auch Kamerabilder zur Erkennung von bestimmten Schaltereignissen innerhalb des Schaltschrankes oder Verteilers liefern. Beispielsweise können innerhalb des Schaltschrankes Lichtbögen entstehen, deren Licht auf Kamerabildern erkennbar ist. Weiterhin kann bei einer möglichen Ausführungsform anhand der Kamerabilder der in der Anzeigeeinheit 6 integrierten Kamera 7 automatisch erkannt werden, an welcher Position bzw. Stelle das Niederspannungsgerät 1 innerhalb des Schaltschrankes oder elektrischen Verteilers montiert ist.

In einer weiteren Ausführungsform ist eine Kamera 7 vorgesehen, die Wärmebilder erzeugt. In der Anzeigefläche der flexiblen Anzeigeeinheit 6 kann somit eine Kamera 7 integriert sein, die Kamerabilder im sichtbaren Frequenzbereich oder in einem nicht sichtbaren Frequenzbereich, insbesondere im Infrarot-Frequenzbereich, erzeugt, die zur Erkennung von Schaltereignissen und/oder lokalen Wärmentwicklungen innerhalb des Schaltschrankes ausgewertet werden.

Anhand der Form und sonstiger Merkmale der übrigen Niederspannungsgeräte 1 innerhalb des Schaltschrankes oder Verteilers kann durch Mustererkennung durch eine Steuereinheit des Schaltschrankes oder Verteilers erkannt werden, welche Art bzw. Typ von Niederspannungsgeräten 1 an welcher Position innerhalb des Schaltschrankes oder Verteilers montiert sind. Hierzu kann eine Steuereinheit 17 des Schaltschrankes oder Verteilers ein trainiertes künstliches Intelligenzmodul aufweisen, insbesondere ein künstliches neuronales Netzwerk (CNN), das es erlaubt, Muster von Objekten innerhalb des Schaltschrankes oder Verteilers zu erkennen bzw. die von den Kameras 7 der Niederspannungsgeräte 1 erhaltenen Bilder bzw. Bilddaten entsprechend zu klassifizieren.

Figuren 4A, 4B zeigen mögliche Ausführungsformen einer in dem Niederspannungsgerät 1 verbaubaren flexiblen Anzeigeeinheit 6. Bei dem in Fig. 4A dargestellten Ausführungsbeispiel ist die Anzeigeeinheit 6 an dem entsprechenden Anzeigegehäuseabschnitt 5 des Gehäuses 2 außen angebracht. Die Anzeigeeinheit 6 kann bei einer möglichen Ausführungsform fest bzw. nicht abnehmbar an dem entsprechenden Gehäuseabschnitt 5 vorgesehen werden. Bei dieser Ausführungsform wird die Anzeigeeinheit 6 beispielsweise an dem Anzeigegehäuseabschnitt 5 angeklebt. Alternativ kann die flexible Anzeigeeinheit 6 auch, wie in Fig. 2 schematisch dargestellt, abnehmbar an dem Anzeigegehäuseabschnitt 5 des Gehäuses 2 aufgesetzt werden.

Fig. 4B zeigt eine weitere Ausführungsvariante, bei der die flexible Anzeigeeinheit 6 innerhalb des Gehäuses 2 eingebettet ist. Dabei besteht das Gehäuse 2 in dem entsprechenden Anzeigegehäuseabschnitt 5 vorzugsweise aus einem transparenten Material, in welchem die flexible Anzeigeschicht der Anzeigeeinheit 6 eingebettet ist. Die flexible Anzeigeschicht weist vorzugsweise eine OLED-Anzeigeschicht auf.

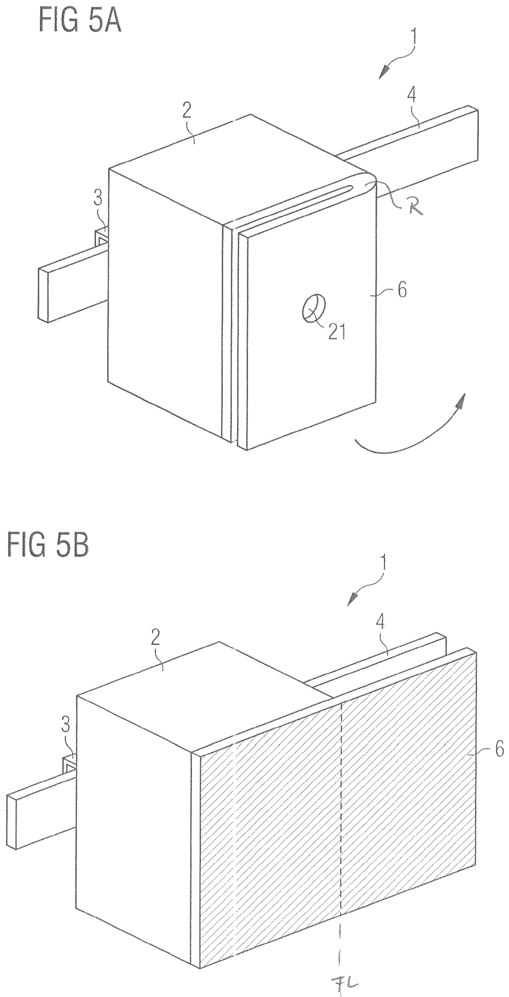

Die Figuren 5A, 5B zeigen eine weitere Ausführungsvariante des erfindungsgemäßen Niederspannungsgerätes 1. Bei dem in den Figuren 5A, 5B dargestellten Ausführungsbeispiel ist die flexible Anzeigeeinheit 6 an einem Anzeigegehäuseabschnitt 5 des Gehäuses 2 in gefalteter Form vorgesehen und kann bei Bedarf von einem Nutzer zur Vergrößerung einer Anzeigefläche der Anzeigeeinheit 6 entfaltet werden, wie in Fig. 5B dargestellt. Bei dem in den Figuren 5A, 5B dargestellten Ausführungsbeispiel ist die entfaltete Anzeigefläche doppelt so groß wie die Vorderfläche des Gehäuses 2 des betreffenden Niederspannungsgerätes 1. Bei einer möglichen Ausführungsform kann die flexible Anzeigeeinheit 6, wie sie in Fig. 5A dargestellt ist, über ein einfaches Anzeigeelement, beispielsweise eine Leuchtdiode 21, verfügen, welche dem Nutzer anzeigt, dass die flexible Anzeigeeinheit 6 zur Anzeige von Informationen entfaltet werden soll. Sobald die Anzeigeeinheit 6 entfaltet worden ist, kann sie unterschiedliche komplexe Informationen hinsichtlich des Betriebszustandes des Niederspannungsgerätes 1 selbst oder anderer Geräte des Schaltschrankes anzeigen. Die Auflösung der Anzeigefläche beträgt beispielsweise bei einer möglichen Implementierung 1440 x 1920 Pixel. Die aktive Anzeigeschicht weist vorzugsweise hierbei eine Dicke von weniger als 0,1 mm auf. Darüber hinaus erlaubt der Biegeradius R von weniger als 1,0 mm ein platzsparendes Einfalten der Anzeigeeinheit 6 aus dem nicht entfaltetem Zustand gemäß Fig. 5A. Im dem gefalteten Zustand gemäß Fig. 5A ist die Anzeigeeinheit 6 zusätzlich vor Umgebungseinflüssen innerhalb der Automatisierungsanlage geschützt, insbesondere gegenüber Staub und Feuchtigkeit. Darüber hinaus bietet der nicht entfaltete Zustand einen Schutz der Anzeigefläche gegenüber mechanischen Einwirkungen oder Umgebungshitze.

Die in den Fig. 5A,5B dargestellte flexible Anzeigeeinheit 6 weist bei einer bevorzugten Ausführungsform eine berührungssensitive Anzeigeschicht zur Eingabe eines Nutzers und zur Anzeige von Informationen an einen Nutzer auf. Bei einer bevorzugten Ausführungsform weist die flexible Anzeigeschicht der Anzeigeeinheit 6 eine OLED (Organic Light-Emitting Diode) -Schicht auf. Die OLED-Anzeigeschicht enthält organische Leuchtdioden und ein leuchtendes Dünnschichtbauelement aus organischen halbleitenden Materialien.

Die flexible Anzeigeeinheit 6 kann eine hintere Trägerschicht ausweisen welche die Anzeigeschicht schützt und trägt. Auf der Anzeigeschicht kann wiederum eine weitere transparente Schutzschicht vorgesehen sein. Sowohl die hintere in der Regel intransparente Trägerschicht als auch die vordere transparente Schutzschicht der Anzeigeeinheit 6 bestehen aus einem flexiblen biegbaren Material, so dass die Anzeigeeinheit 6 an einer oder mehreren Stellen jeweils entlang einer zugehörigen Faltlinie FL entlang mit einem bestimmten Biegeradius R gefaltet und wieder entfaltet werden kann.

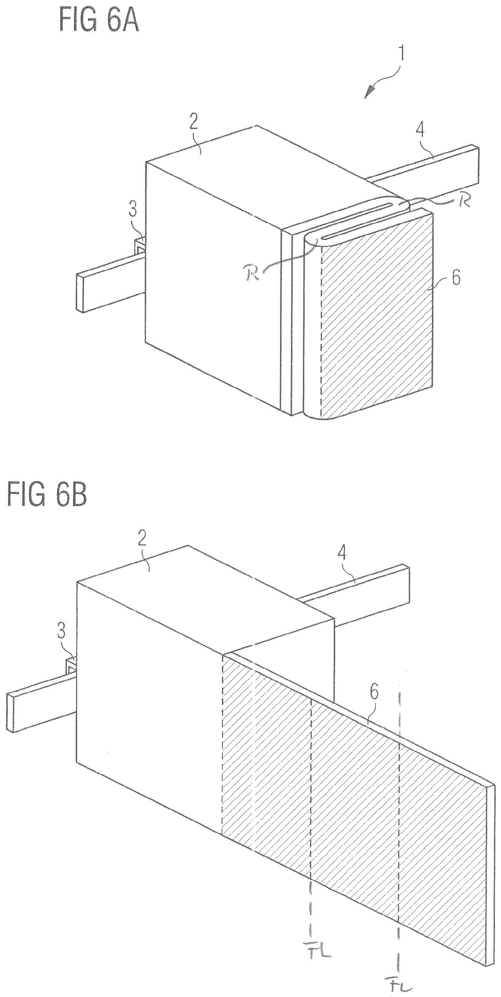

Die durchgängig ausgebildete Anzeigeeinheit 6 kann aufgrund ihrer Flexibilität und der aus elastischen Material bestehenden mindestens einen Trägerschicht an einer oder mehreren Stellen jeweils mit einem bestimmten Biegeradius R gefaltet und anschließend wieder entfaltet werden, ohne dass dies im entfalteten Zustand für einen Nutzer erkennbar wäre. Erst im entfalteten Zustand bildet die Anzeigeeinheit 6 eine flache Ebene, wie in Fig.5B, 6B dargestellt ist.

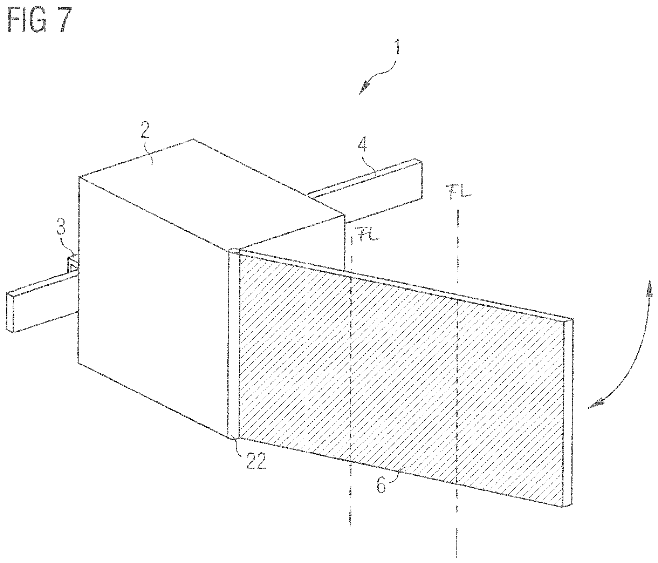

Bei einer weiteren möglichen Ausführungsform, wie sie in Fig. 7 dargestellt ist, kann die flexible Anzeigeeinheit 6 auch mehrfach entfaltet werden. Hierdurch kann die Größe der Anzeigefläche zur Darstellung von Informationen für den Nutzer weiter gesteigert werden. Darüber hinaus ist bei der in Fig. 7 dargestellten Ausführungsvariante die flexible Anzeigeeinheit 6 an dem Gehäuse 2 des Niederspannungsgerätes 1 an einem Schwenkgelenk 22 schwenkbar gelagert. Dies erlaubt es, bei dem dargestellten Ausführungsbeispiel die entfaltete Anzeigeeinheit 6 innerhalb des Verteilers oder Schaltschrankes in horizontaler Ebene parallel zu den horizontal verbauten Schienen 4 zusätzlich zu verschwenken, sodass ein Nutzer die Anzeigeeinheit 6 bei seiner Tätigkeit innerhalb des Schaltschrankes entsprechend betätigen kann. Führt beispielsweise ein Nutzer innerhalb des Schaltschrankes oder Verteilers eine Wartungs- oder Reparaturarbeit aus, kann er die verschwenkbare entfaltete Anzeigeeinheit 6 entsprechend seiner Arbeitsposition verschwenken, um so die auf der Anzeigeeinheit 6 dargestellten Informationen wie beispielsweise eine Reparaturbetriebsanleitung besser sehen zu können. Bei einer möglichen Implementierung kann auch eine Verschwenkung der ausgefalteten flexiblen Anzeigeeinheit 6 in mehreren Richtungen bzw. um verschieden Achsen im Raum ausgeführt werden.

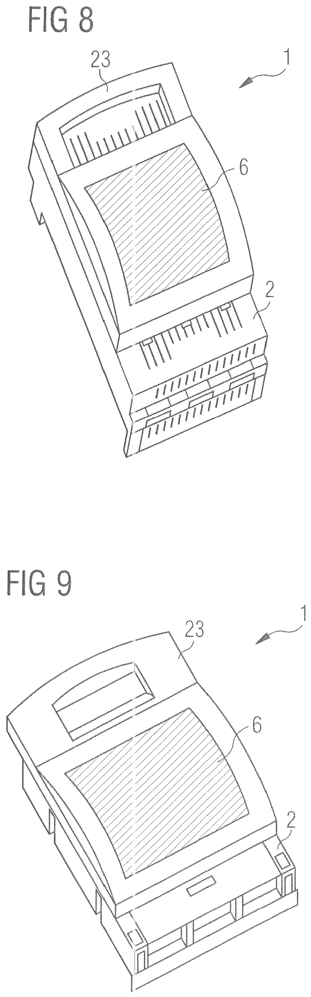

Figuren 8, 9 zeigen beispielhaft mögliche Niederspannungsgeräte 1 mit einer in deren Gehäuse 2 angebrachten flexiblen Anzeigeeinheit 6. In dem Gehäuse 2 des Niederspannungsgerätes 1 können sich, wie in Fig. 8 erkennbar, auch Belüftungsschlitze zur Belüftung interner Bauteile befinden. Bei dem in Fig. 8 dargestellten Ausführungsbeispiel ist die flexible Anzeigeeinheit 6 an einem Anzeigegehäuseabschnitt 5 eines Griffes 23 des Gehäuses 2 angebracht. Fig.9 zeigt eine einen NH-Sicherungs-Lasttrennschalter als Beispiel für ein Niederspannungsgerät 1.

Die flexible Anzeigeeinheit 6 kann im Gehäuse 2 unterschiedlicher Niederspannungsgeräte 1 integriert bzw. daran angebracht werden. Diese Niederspannungsgeräte 1 umfassen beispielsweise einen Lasttrennschalter mit Sicherungen, einen Sicherungslasttrennschalter, einen Lasttrennschalter, einen Leistungsschalter, ein Motorsteuergerät, ein Netzteil, einen Frequenzumrichter oder ein Stromeinspeisemodul für Stromsammelschienen. Je nach Funktionalität des Niederspannungsgerätes 1 können unterschiedliche Informationen auf der Anzeigefläche der flexiblen Anzeigeeinheit 6 dem Nutzer bei Bedarf angezeigt werden. Bei einer bevorzugten Ausführungsform verfügt die Anzeigeeinheit 6 zudem zumindest über eine integrierte Kamera 7 zur Erkennung der Montageumgebung. Die Anzeigeeinheit 6 verfügt über eine Display- und Touchfunktion. Entsprechende Pressflächen zum Aufdrücken einer Fingerkuppe des Nutzers können auf der flexiblen Anzeigeeinheit 6 angezeigt werden. Die in der Anzeigeeinheit 6 integrierte Kamera 7 kann bei einer möglichen Ausführungsform weitere Funktionen liefern. Beispielsweise kann die integrierte Kamera 7 der Anzeigeeinheit 6 bei einer möglichen Implementierung auch biometrische Daten eines Nutzers erfassen, beispielsweise einen Fingerabdruck oder dergleichen. Dies kann zur Autorisierung des Nutzers bzw. Monteurs zur Vornahme von Wartungs- und Reparaturaufgaben an dem Schaltschrank oder Verteiler ausgewertet werden. Die Integration der Kamera 7 innerhalb der flexiblen Anzeigeeinheit 6 ist optional. Bei einer alternativen Ausführungsform kann auch eine separate Kamera 7 neben der berührungssensitiven Anzeigeschicht 6 in dem Gehäuse 2 des Niederspannungsgerätes 1 vorgesehen sein. Auch eine akustische Schnittstelle zur Eingabe von Sprachbefehlen und zur Ausgabe von Warnsignalen kann zusätzlich in dem Gehäuse 2 des Niederspannungsgerätes 1 integriert werden. Die verschiedenen Niederspannungsgeräte 1 innerhalb des Verteilers oder Schaltschrankes können vorzugsweise intern über ein Bussystem miteinander Daten in Echtzeit austauschen, die bei Bedarf an einen Nutzer über eine entsprechende Schnittstelle ausgegeben werden. Über die Kopplung der Steuerung 17 des Niederspannungsgerätes 1 mit einem Intranet oder dem Internet ist es zudem möglich, eine Ferndiagnose des momentanen Betriebszustandes des entsprechenden Niederspannungsgerätes 1 und anderer in der Umgebung des Niederspannungsgerätes 1 vorgesehener Geräte vorzunehmen. Bei einer möglichen Ausführungsform bildet die Kamera 7 eine Webcam zur Übertragung von Kamerabildern an einen entfernten Server des Intranets oder des Internets. Dieser Server befindet sich beispielsweise bei dem Hersteller des Schaltschrankes oder Niederspannungsgerätes 1. Die in dem Gehäuse 2 des Niederspannungsgerätes 1 vorgesehene flexible Anzeigeeinheit 6 kann einen Monteur oder Nutzer in vielfacher Hinsicht, insbesondere bei Vornahme von Reparatur- und Wartungsarbeiten, unterstützen. Beispielsweise können auch IP-Adressen oder sonstige Servicenummern angezeigt werden, die eine direkte Bestellfunktion für die Bestellung von Zubehör oder Ersatzteilen bereitstellen. Beispielsweise kann bei Auftreten einer Fehlfunktion eines Niederspannungsgerätes 1 nicht nur die Fehlfunktion angezeigt werden, sondern zusätzlich eine Bedienanleitung zur Behebung der Fehlfunktion. Schlägt eine Fehlerbehebung fehl, kann dann zusätzlich ein Link auf eine Website zur Bestellung eines entsprechenden Ersatz-Niederspannungsgerätes 1 angezeigt werden, wobei der Nutzer durch Eingeben eines entsprechenden Bestellbefehls auf der berührungssensitiven Anzeigefläche der Anzeigeeinheit 6 einen Bestellvorgang zur Bestellung des Ersatzgerätes auslösen kann. Hierdurch wird die Bestellung eines Ersatzteils nicht nur erheblich beschleunigt, sondern zusätzlich vermieden, dass falsche Ersatzteile nachbestellt werden.

## Patentansprüche

1. Niederspannungsgerät (1) für elektrische Verteiler und Schaltschrankinstallationen mit Bauteilen, die in einem Gehäuse (2) des Niederspannungsgerätes enthalten sind, wobei das Gehäuse (2) des Niederspannungsgerätes (1) aufweist:
- eine Montageschnittstelle (3) zur Montage des Gehäuses (2) an eine entsprechende Gegenschnittstelle des elektrischen Verteilers oder des Schaltschrankes oder an eine im elektrischen Verteiler oder an eine im Schaltschrank eingebaute Komponente;
- einen Anzeigegehäuseabschnitt (5) des Gehäuses (2), der für eine Anzeigeeinheit des Niederspannungsgerätes (1) vorgesehen ist und eine oder mehrere flexibel ausgebildete biegbare und faltbare Anzeigeeinheiten (6) aufweist, **dadurch gekennzeichnet, dass** die flexible Anzeigeeinheit (6) gebogen an eine Kontur des Anzeigegehäuseabschnittes (5) des Gehäuses (2) des Niederspannungsgerätes (1) angepasst vorgesehen ist oder gefaltet an dem Anzeigegehäuseabschnitt (5) des Gehäuses (2) des Niederspannungsgerätes (1) vorgesehen ist und dort zur Vergrößerung einer Anzeigefläche der Anzeigeeinheit (6) entfaltbar ist.

2. Niederspannungsgerät nach Anspruch 1,
wobei die flexible Anzeigeeinheit (6) eine Anzeigeschicht mit einer Dicke von weniger als 1 mm aufweist, und/oder wobei die flexible Anzeigeeinheit (6) eine Anzeigeschicht mit einem Biegeradius von weniger als 10 mm aufweist.

3. Niederspannungsgerät nach Anspruch 1 oder 2,
wobei die flexible Anzeigeeinheit (6) eine berührungssensitive Anzeigeschicht für Nutzereingaben eines Nutzers und zur Anzeige von Informationen an einen Nutzer aufweist.

4. Niederspannungsgerät nach einem der vorangehenden Ansprüche 1 bis 3,
wobei das Gehäuse (2) des Niederspannungsgerätes (1) eine Montageschnittstelle (3) zur Montage des Niederspannungsgerätes (1) an mindestens eine Stromsammelschiene (4) eines Sammelschienensystems des Schaltschrankes und zur elektrischen Kontaktierung der Stromsammelschiene (4) aufweist, oder
wobei das Gehäuse (2) des Niederspannungsgerätes (1) eine Montageschnittstelle zur Montage des Niederspannungsgerätes (1) auf eine Hutschiene oder auf eine Montageplatte des Schaltschrankes aufweist.

5. Niederspannungsgerät nach einem der vorangehenden Ansprüche,
wobei die flexible Anzeigeeinheit (6) an eine an dem Anzeigegehäuseabschnitt (5) des Gehäuses (2) des Niederspannungsgerätes (1) vorgesehene Datenschnittstelle (9) und/oder an eine Stromversorgungsschnittstelle abnehmbar angebracht ist,
wobei die flexible Anzeigeeinheit (6) nach dem Abnehmen von dem Gehäuse (2) des Niederspannungsgerätes (1) eingeschaltet bleibt, wobei ein Datenaustauch über eine drahtgebundene oder drahtlose Datenverbindung erfolgt und wobei eine Stromversorgung der der von dem Gehäuse (2) des Niederspannungsgerätes (1) abgenommenen Anzeigeeinheit (6) über eine Stromverbindung oder durch eine in der Anzeigeeinheit (6) integrierten Energiespeicher erfolgt.

6. Niederspannungsgerät nach einem der vorangehenden Ansprüche,
wobei der Anzeigegehäuseabschnitt (5) des Gehäuses (2) des Niederspannungsgerätes (1) aus einem transparenten Material besteht, in welchem die flexible Anzeigeschicht der Anzeigeeinheit (6) eingebettet ist.

7. Niederspannungsgerät nach einem der vorangehenden Ansprüche 1 bis 6,
wobei die in dem Gehäuse (2) des Niederspannungsgerätes (1) enthaltenen Bauteile des Niederspannungsgerätes (1) Leistungsbauteile aufweisen, die während des Betriebes des Niederspannungsgerätes (1) Wärme erzeugen, und
wobei der für die flexible Anzeigeeinheit (6) vorgesehene Anzeigegehäuseabschnitt (5) des Gehäuses (2) des Niederspannungsgerätes (1) oder die Anzeigeeinheit (6) durch eine Wärmeisolierung von den Leistungsbauteilen des Niederspannungsgerätes (1) zum Schutz der flexiblen Anzeigeeinheit (6) wärmeisoliert ist.

8. Niederspannungsgerät nach einem der vorangehenden Ansprüche 1 bis 7,
wobei in der Anzeigefläche der flexiblen Anzeigeeinheit (6) eine Kamera (7) integriert ist, die Kamerabilder im sichtbaren Frequenzbereich oder in einem nicht sichtbaren Frequenzbereich, insbesondere im Infrarot-Frequenzbereich; erzeugt.

9. Niederspannungsgerät nach einem der vorangehenden Ansprüche 1 bis 8,
wobei das Niederspannungsgerät (1) aufweist:
einen Lasttrennschalter mit Sicherungen,
einen Sicherungslasttrennschalter,
einen Lasttrennschalter,
einen Leistungsschalter,
ein Motorsteuergerät,
ein Netzteil,
einen Frequenzumrichter und/oder
ein Stromeinspeisemodul.

10. Niederspannungsgerät nach einem der vorangehenden Ansprüche 1 bis 9,
wobei die auf der flexiblen Anzeigeeinheit (6) des Niederspannungsgerätes (1) angezeigten Informationen aufweisen:
- Statusinformationen des Niederspannungsgerätes oder anderer in dem Schaltschrank montierter Niederspannungsgeräte,
- Konfigurationsangaben des Niederspannungsgerätes oder anderer in dem Schaltschrank montierter Niederspannungsgeräte,
- Messdaten des Niederspannungsgerätes oder anderer in dem Schaltschrank montierter Niederspannungsgeräte,
- einen Stromlaufplan des Niederspannungsgerätes und/oder eines anderen in dem Schaltschrank montierten Niederspannungsgerätes oder einen Stromlaufplan der in dem Schaltschrank montierten Niederspannungsgeräte,
- eine Betriebsanleitung für den Betrieb des Niederspannungsgerätes oder des Schaltschrankes,
- eine Servicenummer für einen Wartungsservice zur Wartung des Schaltschrankes und/oder des Niederspannungsgerätes oder weiterer Niederspannungsgeräte innerhalb des Schaltschrankes und/oder
- Statusinformationen einer an dem Niederspannungsgerät angeschlossenen Last.

11. Niederspannungsgerät nach einem der Ansprüche 1 bis 10, wobei die entfaltete flexible Anzeigeeinheit (6) schwenkbar an dem Gehäuse (2) des Niederspannungsgerätes (1) angebracht ist.

12. Niederspannungsgerät nach einem der Ansprüche 1 bis 11, wobei eine entfaltete flexible Anzeigeeinheit (6) des Niederspannungsgerätes (1) mit einer weiteren entfalteten flexiblen Anzeigeeinheit (6) eines auf der Schiene des Schaltschrankes daneben montierten Niederspannungsgerätes (1) eine zusammengesetzte Anzeigeeinheit mit großer Anzeigefläche bildet.

13. Niederspannungsgerät nach einem der Ansprüche 1 bis 12, wobei die Anzeigeeinheit (6) des Niederspannungsgerätes (1) über ein drahtgebundenes oder drahtloses Bussystem des Schaltschrankes mit anderen Geräten des Schaltschrankes, insbesondere mit anderen Niederspannungsgeräten (1) des Schaltschrankes, zur Datenübertragung verbunden ist.

14. Niederspannungsgerät nach einem der Ansprüche 1 bis 13, wobei die Anzeigeeinheit (6) des Niederspannungsgerätes (1) an ein Intranet einer Automatisierungsanlage und/oder über ein Gateway an das Internet angebunden ist.

15. Niederspannungsgerät nach einem der Ansprüche 1 bis 14, wobei die Anzeigeeinheit (6) an eine Nutzerschnittstelle des Niederspannungsgerätes (1) und/oder des Schaltschrankes gekoppelt ist.

16. Niederspannungsgerät nach einem der vorangehenden Ansprüche 2 bis 15, wobei die flexible Anzeigeeinheit (6) eine flexible hintere Trägerschicht zum Tragen der Anzeigeschicht der Anzeigeeinheit (6) und eine flexible vordere transparente Schutzschicht zum Schutz der Anzeigeschicht der Anzeigeschicht (6) aufweist.

17. Schaltschrank mit mindestens einem darin montierten Niederspannungsgerät (1) nach einem der Ansprüche 1 bis 16.

## Claims

1. A low-voltage device (1) for electrical distribution boards and switching cabinet installations with components comprised in a housing (2) of the low-voltage device, wherein the housing (2) of the low-voltage device (1) comprises:
- a mounting interface (3) for mounting the housing (2) to a corresponding mating interface of the electrical distribution board or the switching cabinet or to a component installed in the electrical distribution board or in the switching cabinet;
- a display housing portion (5) of the housing (2), which is provided for a display unit of the low-voltage device (1) and comprises one or more flexibly formed bendable and foldable display units (6),
**characterized in that**
the flexible display unit (6) is provided bent to fit a contour of the display housing portion (5) of the housing (2) of the low-voltage device (1), or folded on the display housing portion (5) of the housing (2) of the low-voltage device (1) and is unfoldable there to enlarge a display surface of the display unit (6).

2. The low-voltage device according to claim 1, wherein the flexible display unit (6) comprises a display layer with a thickness of less than 1 mm, and/or the flexible display unit (6) comprises a display layer with a bending radius of less than 10 mm.

3. The low-voltage device according to claim 1 or 2, wherein the flexible display unit (6) comprises a touch-sensitive display layer for user input by a user and for displaying information to a user.

4. The low-voltage device according to one of the preceding claims 1 to 3, wherein the housing (2) of the low-voltage device (1) comprises a mounting interface (3) for mounting the low-voltage device (1) to at least one current busbar (4) of a current busbar system of the switching cabinet and for electrically contacting the current busbar (4), or wherein the housing (2) of the low-voltage device (1) comprises a mounting interface for mounting the low-voltage device (1) to a top-hat rail or to a mounting plate of the switching cabinet.

5. The low-voltage device according to one of the preceding claims, wherein the flexible display unit (6) is detachably attached to a data interface (9) provided on the display housing portion (5) of the housing (2) of the low-voltage device (1) and/or to a power supply interface, wherein the flexible display unit (6) stays switched on after detachment from the housing (2) of the low-voltage device (1), wherein data is exchanged via a wired or wireless data connection and wherein a power supply to the display unit (6) detached from the housing (2) of the low-voltage device (1) is realized via a power connection or by an energy storage unit integrated in the display unit (6).

6. The low-voltage device according to one of the preceding claims, wherein the display housing portion (5) of the housing (2) of the low-voltage device (1) consists of a transparent material in which the flexible display layer of the display unit (6) is embedded.

7. The low-voltage device according to one of the preceding claims 1 to 6, in which the components in the housing (2) of the low-voltage device (1) comprise components of the low-voltage device (1) that generate heat or warmth during operation of the low-voltage device (1), and wherein the display housing portion (5) of the housing (2) of the low-voltage device (1) provided for the flexible display unit (6) or the display unit (6) is thermally insulated from the power components of the low-voltage device (1) by a thermal insulation for the protection of the flexible display unit (6).

8. The low-voltage device according to one of the preceding claims 1 to 7, wherein in the display area of the flexible display unit (6) a camera (7) is integrated, which generates camera images in the visible frequency range or in an invisible frequency range, especially in an infrared frequency range.

9. The low-voltage device according to one of the preceding claims 1 to 8, wherein the low-voltage device (1) comprises:
a load-break switch with fuses,
a fuse switch disconnector,
a switch disconnector,
a circuit breaker,
a motor control unit,
a power supply unit,
a frequency converter and/or
a power feed-in module.

10. The low-voltage device according to one of the preceding claims 1 to 9, wherein the information displayed on the flexible display unit (6) of the low-voltage device (1) comprises:
- status information of the low-voltage device or other low-voltage devices mounted in the switching cabinet,
- configuration details of the low-voltage device or other low-voltage devices mounted in the switching cabinet,
- measurement data of the low-voltage device or other low-voltage devices mounted in the switching cabinet,
- a circuit diagram of the low-voltage device and/or another low-voltage device mounted in the switching cabinet or a circuit diagram of the low-voltage devices mounted in the switching cabinet,
- operating instructions for operating the low-voltage device or the switching cabinet,
- a service number for a maintenance service for servicing the switching cabinet and/or the low-voltage device or other low-voltage devices within the switching cabinet and/or
- status information of a load connected to the low-voltage device.

11. The low-voltage device according to any one of claims 1 to 10, wherein the unfolded flexible display unit (6) is pivotably attached to the housing (2) of the low-voltage device (1).

12. The low-voltage device according to any one of claims 1 to 11, wherein an unfolded flexible display unit (6) of the low-voltage device (1) forms, together with another unfolded flexible display unit (6) of a low-voltage device mounted adjacently on the rail of the switching cabinet, a composite display unit with a large display area.

13. The low-voltage device according to any one of claims 1 to 12, wherein the display unit (6) of the low-voltage device (1) is connected via a wired or wireless bus system of the switching cabinet with other devices of the switching cabinet, in particular with other low-voltage devices (1) of the switching cabinet, for data transmission.

14. The low-voltage device according to any one of claims 1 to 13, wherein the display unit (6) of the low-voltage device (1) is connected to an intranet of an automation system and/or to the Internet via a gateway.

15. The low-voltage device according to any one of claims 1 to 14, wherein the display unit (6) is coupled to a user interface of the low-voltage device (1) and/or of the switching cabinet.

16. The low-voltage device according to any one of the preceding claims 2 to 15, wherein the flexible display unit (6) comprises a flexible rear support layer for supporting the display layer of the display unit (6) and a flexible front transparent protective layer for protecting the display layer of the display layer (6).

17. Switching cabinet with at least one low-voltage devices (1) according to any of claims 1 to 16 mounted therein.

## Revendications

1. Dispositif basse tension (1) pour des répartiteurs électriques et des installations d'armoires de distribution avec des composants qui sont contenus dans un boîtier (2) du dispositif basse tension, dans lequel le boîtier (2) du dispositif basse tension (1) comporte :
- une interface de montage (3) pour le montage du boîtier (2) sur une interface complémentaire correspondante du répartiteur électrique ou de l'armoire de distribution ou sur un composant monté dans le répartiteur électrique ou dans l'armoire de distribution ;
- une portion de boîtier d'affichage (5) du boîtier (2) qui est prévue pour une unité d'affichage du dispositif basse tension (1) et comporte une ou plusieurs unités d'affichage (6) incurvables et pliables réalisées de manière souple,
**caractérisé en ce que**
l'unité d'affichage souple (6) est prévue incurvée et adaptée à un contour de la portion de boîtier d'affichage (5) du boîtier (2) du dispositif basse tension (1) ou pliée sur la portion de boîtier d'affichage (5) du boîtier (2) du dispositif basse tension (1) et peut y être dépliée pour agrandir une surface d'affichage de l'unité d'affichage (6).

2. Dispositif basse tension selon la revendication 1,
dans lequel l'unité d'affichage souple (6) comporte une couche d'affichage ayant une épaisseur inférieure à 1 mm et/ou dans lequel l'unité d'affichage souple (6) comporte une couche d'affichage ayant un rayon de courbure inférieur à 10 mm.

3. Dispositif basse tension selon la revendication 1 ou 2,
dans lequel l'unité d'affichage souple (6) comporte une couche d'affichage tactile pour des entrées d'utilisateur d'un utilisateur et pour afficher des informations à un utilisateur.

4. Dispositif basse tension selon l'une des revendications 1 à 3 précédentes,
dans lequel le boîtier (2) du dispositif basse tension (1) comporte une interface de montage (3) pour le montage du dispositif basse tension (1) sur au moins une barre omnibus électrique (4) d'un système de barres omnibus élecrique de l'armoire de distribution et pour la mise en contact électrique de la barre omnibus électrique (4), ou
dans lequel le boîtier (2) du dispositif basse tension (1) comporte une interface de montage pour le montage du dispositif basse tension (1) sur un profilé chapeau ou sur une plaque de montage de l'armoire de distribution.

5. Dispositif basse tension selon l'une des revendications précédentes,
dans lequel l'unité d'affichage souple (6) est rapportée de manière détachable sur une interface de données (9) prévue sur la portion de boîtier d'affichage (5) du boîtier (2) du dispositif basse tension (1) et/ou sur une interface d'alimentation électrique,
dans lequel l'unité d'affichage souple (6) reste sous tension après le détachement du boîtier (2) du dispositif basse tension (1), dans lequel un échange de données s'effectue par l'intermédiaire d'une connexion de données filaire ou sans fil et dans lequel une alimentation électrique de l'unité d'affichage (6) détachée du boîtier (2) du dispositif basse tension (1) s'effectue par l'intermédiaire d'une connexion électrique ou par un accumulateur d'énergie intégré dans l'unité d'affichage (6).

6. Dispositif basse tension selon l'une des revendications précédentes,
dans lequel la portion de boîtier d'affichage (5) du boîtier (2) du dispositif basse tension (1) est constituée d'un matériau transparent dans lequel la couche d'affichage souple de l'unité d'affichage (6) est incorporée.

7. Dispositif basse tension selon l'une des revendications 1 à 6 précédentes,
dans lequel les composants du dispositif basse tension (1) contenus dans le boîtier (2) du dispositif basse tension (1) comportent des composants de puissance qui génèrent de la chaleur pendant le fonctionnement du dispositif basse tension (1), et dans lequel la portion de boîtier d'affichage (5) du boîtier (2) du dispositif basse tension (1) prévue pour l'unité d'affichage souple (6) ou l'unité d'affichage (6) est isolée thermiquement par une isolation thermique des composants de puissance du dispositif basse tension (1) afin de protéger l'unité d'affichage souple (6).

8. Dispositif basse tension selon l'une des revendications 1 à 7 précédentes,
dans lequel, dans la surface d'affichage de l'unité d'affichage souple (6), une caméra (7) est intégrée, qui produit des images de caméra dans la plage de fréquences visibles ou dans une plage de fréquences non visibles, en particulier dans la plage de fréquences de l'infrarouge.

9. Dispositif basse tension selon l'une des revendications 1 à 8 précédentes,
dans lequel le dispositif basse tension (1) comporte :
un interrupteur-sectionneur à fusibles,
un fusible-interrupteur-sectionneur,
un interrupteur-sectionneur,
un disjoncteur,
un dispositif de commande du moteur,
un bloc d'alimentation,
un convertisseur de fréquence et/ou
un module d'alimentation électrique.

10. Dispositif basse tension selon l'une des revendications 1 à 9 précédentes,
dans lequel les informations affichées sur l'unité d'affichage souple (6) du dispositif basse tension (1) comportent :
- des informations d'état du dispositif basse tension ou d'autres dispositifs basse tension montés dans l'armoire de distribution,
- des détails de configuration du dispositif basse tension ou d'autres dispositifs basse tension montés dans l'armoire de distribution,
- des données de mesure du dispositif basse tension ou d'autres dispositifs basse tension montés dans l'armoire de distribution,
- un schéma de circuits du dispositif basse tension et/ou d'un autre dispositif basse tension monté dans l'armoire de distribution ou un schéma de circuits des dispositifs basse tension montés dans l'armoire de distribution,
- des instructions de fonctionnement pour le fonctionnement du dispositif basse tension ou de l'armoire de distribution,
- un numéro de service pour un service de maintenance pour la maintenance de l'armoire de distribution et/ou du dispositif basse tension ou d'autres dispositifs basse tension à l'intérieur de l'armoire de distribution et/ou
- des informations d'état d'une charge raccordée au dispositif basse tension.

11. Dispositif basse tension selon l'une des revendications 1 à 10,
dans lequel l'unité d'affichage souple (6) dépliée est rapportée de façon à pouvoir pivoter sur le boîtier (2) du dispositif basse tension (1).

12. Dispositif basse tension selon l'une des revendications 1 à 11,
dans lequel une unité d'affichage souple (6) dépliée du dispositif basse tension (1) forme, avec une unité d'affichage souple (6) supplémentaire dépliée d'un dispositif basse tension (1) monté de manière adjacente sur le rail de l'armoire de distribution, une unité d'affichage composite ayant une grande surface d'affichage.

13. Dispositif basse tension selon l'une des revendications 1 à 12,
dans lequel l'unité d'affichage (6) du dispositif basse tension (1) est reliée, via un système de bus filaire ou sans fil de l'armoire de distribution, à d'autres dispositifs de l'armoire de distribution, en particulier à d'autres dispositifs basse tension (1) de l'armoire de distribution, pour la transmission de données.

14. Dispositif basse tension selon l'une des revendications 1 à 13,
dans lequel l'unité d'affichage (6) du dispositif basse tension (1) est connectée à un intranet d'une installation d'automatisation et/ou à Internet via une passerelle.

15. Dispositif basse tension selon l'une des revendications 1 à 14,
dans lequel l'unité d'affichage (6) est couplée à une interface utilisateur du dispositif basse tension (1) et/ou de l'armoire de distribution.

16. Dispositif basse tension selon l'une des revendications 2 à 15 précédentes,
dans lequel l'unité d'affichage souple (6) est une couche de support arrière souple pour supporter la couche d'affichage de l'unité d'affichage (6) et une couche de protection transparente avant souple pour protéger la couche d'affichage de la couche d'affichage (6).

17. Armoire de commande dans laquelle est monté au moins un dispositif basse tension (1) selon l'une des revendications 1 à 16.
